(19) Europäisches Patentamt
European Patent Office
Office européen des brevets

(11) **EP 3 301 207 A1**

(12) **EUROPEAN PATENT APPLICATION**

(43) Date of publication:
**04.04.2018 Bulletin 2018/14**

(51) Int Cl.:
*C30B 7/06* *(2006.01)*  *C23C 14/00* *(2006.01)*
*C30B 23/02* *(2006.01)*  *C30B 25/18* *(2006.01)*
*C30B 29/54* *(2006.01)*

(21) Application number: **16191209.2**

(22) Date of filing: **28.09.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicants:
• **IMEC VZW**
**3001 Leuven (BE)**

• **Katholieke Universiteit Leuven**
**3000 Leuven (BE)**

(72) Inventors:
• **Janneck, Robby**
**3001 Leuven (BE)**
• **Rolin, Cedric**
**3001 Leuven (BE)**

(74) Representative: **DenK iP**
**Leuvensesteenweg 203**
**3190 Boortmeerbeek (BE)**

(54) **CRYSTALLINE ORGANIC FILMS**

(57)    In a first aspect, the present invention relates to a method for forming a crystalline organic film, comprising the steps of:
a. providing, by a directional technique, a first crystalline layer of a first organic material on top of a substrate, and
b. providing, by a vapour-based deposition technique, a second crystalline layer of the first organic material or of a second organic material on top of the first crystalline layer of the first organic material.

FIG. 8

**Description**

**Technical field of the invention**

The present invention relates to crystalline organic films and in particular to the manufacture of crystalline organic films.

**Background of the invention**

Organic single-crystalline thin films offer great potential for fundamental material studies as well as for realizing high-performance, low-cost flexible electronics. The latest generation of organic semiconducting materials display excellent characteristics, with charge mobilities surpassing those of amorphous silicon thin film transistors (TFTs), which are commonly used in today's flat panel displays.

The integration of organic TFTs (OTFTs) into real applications, requires high performance and low variability of the electrical characteristics. As the transport properties are greatly influenced by the morphology and microstructure of the organic layer, single-crystalline layers offer the greatest potential for high performance applications. Large effort has therefore been spent into the development of fabrication techniques that can form single crystalline thin films on large area inert substrates. The most promising techniques, such as meniscus guided coating (MGC) techniques or techniques based on thermal gradients, all employ a unidirectional solidification approach that separates the function of nucleation and subsequent growth.

Although these techniques yield thin films with large single crystalline regions, each method presents its own inherent challenges concerning defect formation. Thermal gradients are prone to form cracks in the thin film due to different thermal expansion coefficients of the substrate and the organic semiconductor. MGC techniques, on the other hand, lead to void formation and dendritic growth; as e.g. described in U. Thiele et al., Adv. Colloid Interface Sci. 2014, 206, 399. These issues may for example be due to slip-stick motion of the meniscus, fingering instabilities in the receding contact line and/or mass-flow limitations in the supply of solute to the growing crystal front. Furthermore, MGC coating at elevated temperatures has also been shown to lead to crack formation in the film; as shown in Y. Li et al., Sci. Rep. 2016, 6, 32620. As such, the layers resulting from these techniques typically exhibit morphological defects in the form of cracks, voids or ribbon-like growth that affect the film over different length scales and along different directions. Such defects lower the electrical performance and are a major cause for variability in transport characteristics within these films.

Despite broad efforts to optimize growth recipes and improve setups, the formation of smooth and uniform single crystalline films has remained elusive in these kinetically driven solidification processes. There is thus still a need within the art for methods for the fabrication of better organic crystalline films.

**Summary of the invention**

It is an object of the present invention to provide good methods for fabricating good organic crystalline films.

It is an advantage of embodiments of the present invention that these films may be single-crystalline films or films consisting of directed single-crystalline domains.

It is an advantage of embodiments of the present invention that morphological defects, such as cracks, voids or ribbon-like growth, in films obtained by conventional directional solidification methods can be corrected.

It is an advantage of embodiments of the present invention that the films can be formed over a large substrate area. It is a further advantage of embodiments of the present invention that the substrate may be uniformly covered by the film over this area.

It is an advantage of embodiments of the present invention that the variability of characteristics of the film, such as the electrical charge carrier mobilities, can be improved.

It is an advantage of embodiments of the present invention that the electrical characteristics of the film, such as the charge carrier mobilities, can be improved.

The above objective is accomplished by a method and device according to the present invention.

In a first aspect, the present invention relates to a method for forming a crystalline organic film, comprising the steps of:

> a. providing, by a directional technique, a first crystalline layer of a first organic material on top of a substrate, and
> b. providing, by a vapour-based deposition technique, a second crystalline layer of the first organic material or of a second organic material on top of the first crystalline layer of the first organic material.

In a second aspect, the present invention relates to a structure obtainable by the method of any embodiment of the first aspect.

In a first mode of realization, the second aspect of the present invention relates to a structure comprising:

i. a substrate,
ii. a crystalline organic film made of a single material, overlying the substrate, comprising a bottom part in contact with the substrate, said bottom part being continuous, homogeneous, single-crystalline and spanning the whole area of the crystalline organic film, said area being at least 10 $\mu m^2$.

In a second mode of realization, the second aspect of the present invention relates to a structure comprising:

i. a substrate,
ii. a crystalline organic film overlying the substrate, comprising

ii.a. a first crystalline layer of a first organic material on top of the substrate, the first crystalline layer comprising a morphological defect,
ii.b. a second crystalline layer of a second organic material, on top of the first crystalline layer and at least partially filling the morphological defect.

In a third aspect, the present invention relates to a use of a vapour deposition apparatus to repair defects in a crystalline organic film deposited by a directional technique.

In a further aspect, the present invention relates to the manufacture of a thin film transistor comprising the steps of providing a substrate and forming an assembly thereon, the assembly comprising a gate layer, a dielectric layer, a semiconductor crystalline organic film, a source and a drain contact, wherein:

a. the dielectric layer separates the gate layer from the semiconductor crystalline organic film,
b. the source and the drain contact are in physical and electrical contact with the semiconductor crystalline organic film, wherein the semiconductor crystalline organic film is formed by:

o providing, by a directional technique, a first crystalline layer of a first semiconductor organic material, and
o providing, by a vapour-based deposition technique, a second crystalline layer of the first semiconductor organic material or of a second semiconductor organic material on top of the first crystalline layer of the first organic material.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

Fig. 1 shows atomic force microscopy (AFM) images of zone casted films with increasing amount of additional evaporated monolayers, as well as a depth profile for the line indicated in Fig. 1j; in accordance with an embodiment of the present invention.

Fig. 2 shows scanning transmission X-ray microscopy (STXM) images recording the transmitted photons (enabling bulk sensitivity) for a) a zone-casted film according to the prior art, b) a 10 monolayers thick evaporated film according to the prior art and c) after epitaxial regrowth of 10 monolayers on top of a zone casted film in accordance with an embodiment of the present invention.

Fig. 3 shows an STXM image recording the photo-emitted electrons (enabling surface sensitivity) performed on the sample corresponding to Fig. 2c.

Fig. 4 shows the hole mobility in function of an increasing amounts of evaporated monolayers; in accordance with an embodiment of the present invention (3) and compared to samples where step a is absent (2).

Fig. 5 shows a comparison of the electrical characteristics between a sample, wherein the first and second organic material are the same, according to an embodiment of the present invention (3), a reference zone casted sample (step a only; 1) and a reference evaporated sample (step b only; 2).

Fig. 6 shows a comparison of the electrical characteristics between a sample, wherein the first and second organic material are different, according to an embodiment of the present invention (3), a reference zone casted sample (step a only; 1) and a reference evaporated sample (step b only; 2).

Fig. 7 is a graph comparing the contact resistance at different voltages for films obtained according to methods of the prior art (step a only, 1; and step b only, 2) and for a film obtained according to an embodiment of the present invention (3).

Fig. 8 is a flowchart showing the main steps of the method according to the present invention.

In the different figures, the same reference signs refer to the same or analogous elements.

**Description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

Reference will be made to transistors. These are devices having a first main electrode such as a drain, a second main electrode such as a source and a control electrode such as a gate for controlling the flow of electrical charges between the first and second main electrodes.

The following term is provided solely to aid in the understanding of the invention.

As used herein, a morphological defect in a crystalline layer is an opening, such as a crack or a void, within the crystalline layer. In this context, a domain boundary between two single-crystalline domains as such, where the domain boundary does not comprise an opening in the crystalline layer, is not considered to be a morphological defect in the crystalline layer.

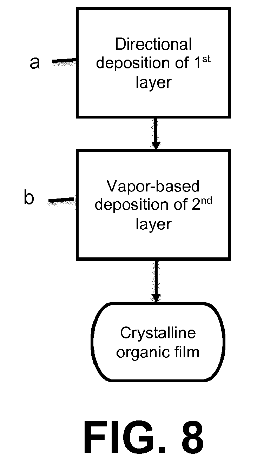

In a first aspect, the present invention relates to a method for forming a crystalline organic film (see Fig. 8), comprising the steps of:

a. providing, by a directional technique, a first crystalline layer of a first organic material on top of a substrate, and
b. providing, by a vapour-based deposition technique, a second crystalline layer of the first organic material or of a second organic material on top of the first crystalline layer of the first organic material.

The crystalline organic film of the present invention may in some embodiments be referred to as a crystalline organic thin film. In embodiments, the crystalline organic film may have a maximal thickness (typically away from defects of the first layer) and a minimal thickness (at the location of defects of the first layer). In embodiments, the crystalline organic film may have a maximal thickness of from 40 nm to 5 $\mu$m, preferably from 40 nm to 90 nm. Films for use in e.g. organic thin film transistors (OTFTs) may typically have a maximal thickness of 90 nm or below, whereas films for use in e.g. optical applications may have a maximal thickness up to several micrometres such as e.g. 5 $\mu$m.

In embodiments, the crystalline organic film may have a minimal thickness of from 10 nm to 5 $\mu$m, preferably from 10 nm to 60 nm. Films for use in e.g. organic thin film transistors (OTFTs) may typically have a minimal thickness of 60 nm or below. Conversely, films for use in e.g. optical applications may have a minimal thickness of from 50 nm up to several micrometres such as e.g. up to 50 $\mu$m; for example: films for organic solar cells and for polarized light generation may typically have a thickness of from 50 nm to 1 $\mu$m, films for NLO applications may typically have a thickness of from 100 nm to 5 $\mu$m and films for direct high-energy wave and particle detection may typically have a thickness of from 100 nm to 50 $\mu$m. For thick films of one micron or more, the notion of minimal and maximal thickness lose relevancy since the change in thickness between minimal and maximal values become insignificant compared to the maximal values.

The substrate may for example comprise a dielectric material.

It was surprisingly found within the present invention that a crystalline organic film obtained by the method of the first aspect is of a significantly improved quality as compared to films obtained by either step a or step b alone. This quality improvement is exemplified in the very high (hole) mobilities obtained in crystalline organic semiconductor films in accordance with embodiments of the present invention (see example 3 and 4). Without being bound by theory, this quality improvement is attributed to a correction, by step b, of morphological defects, such as cracks or voids, in the first crystalline layer after step a. This correction typically takes the form of filling up the cracks and/or voids.

In embodiments, the first crystalline layer provided in step a may comprise at least a morphological defect. In preferred embodiments, the morphological defect opens up to a top of the first crystalline layer, the top being away from the substrate. In embodiment, the first crystalline layer may be composed of one or more single-crystalline domains and the at least one morphological defect may be present in at least one of the one or more single-crystalline domains and/or between two or more of the single-crystalline domains. For example: the layer may comprise several ribbon-like growth structures (i.e. single-crystalline domains) with voids (i.e. morphological defects) therebetween, or the layer may comprise a single-crystalline film (i.e. a single-crystalline domain) with one or more cracks (i.e. morphological defects) therein.

The ribbon-shaped single-crystalline domains may for instance have a length of 0.5 $\mu$m or more, such as from 0.5 $\mu$m to 10 m, and a width of from 0.5 to 20 $\mu$m, preferably from 1 to 10 $\mu$m. The voids between the ribbon-shaped single-crystalline domains may for instance have a length of 0.5 $\mu$m or more, such as from 0.5 $\mu$m to 10 m, and a width of from 0.1 to 10 $\mu$m, preferably from 0.5 to 5 $\mu$m.

In embodiments, step b may at least partially fill the at least one morphological defect with a crystalline layer of the first organic material or of a second organic material. In embodiments, the at least one morphological defect may have a bottom in contact with the substrate and a top away from the substrate, and step b may fill completely the bottom of the at least one morphological defect.

In preferred embodiments, the second crystalline layer may be a layer of the first organic material and the filling occurring in step b may operate by homoepitaxial growth within the morphological defect. In such a case, the crystalline domains present in the layer after step a typically expand during step b due to the homoepitaxial growth. Films wherein the first and the second organic material are the same material and wherein the morphological defects are, at least partially, homoepitaxially filled display the largest quality improvement as compared to films obtained by either step a or step b alone (see example 2 and 3).

In other embodiments, the second crystalline layer may be a layer of a material different than the first organic material. The filling within the morphological defect occurring in step b in such a case is not typically homoexpitaxial. Thus, a quality improvement of the film still occurs as the morphological defect(s) in the film are filled, but the effect is smaller than when the filling is homoepitaxial in nature. Indeed, when the first and second organic material are different, while the second organic material can typically form a crystalline layer and may even fill the morphological defect in a crystalline way, the crystalline domains of the second material and the first material will typically display a different crystallinity. As such, the crystalline domains of the first material will in this case not expand during step b, thus not resulting in the best possible quality improvement. Nevertheless, using two different materials may be advantageous as each can be chosen and optimized for their specific method of provision, i.e. directional technique for the first organic material and vapour-based deposition technique for the second organic material, as a randomly chosen organic material is not necessarily suitable for both methods. Furthermore, this approach can advantageously be used to shift an unfavourable threshold voltage of a first organic material by combining it with a second organic material which has a more suitable threshold voltage.

In embodiments, the first and second organic materials may be semiconductor materials. A film wherein the first and second organic materials are semiconductor materials is advantageously suitable for use in thin film transistors (TFTs) or in some optical applications, such as solar cells or (polarized) light emitting diodes. In embodiments, the first and the second organic materials may be organic materials with non-linear optical (NLO) properties, such as 4-dimethylamino-N-methyl-4-stilbazolium tosylate (DAST), 2-(3-(4-hydroxystyryl)-5,5-dimethylcyclohex-2-enylidene) malononitrile (OH1) or N-benzyl 2-methyl-4-nitroaniline (BNA). A film wherein the first and the second organic materials are organic materials with NLO properties is, for example, advantageously suitable for use in optical modulators based on NLO effects. In embodiments, the first and the second organic materials may be materials suitable for the detection of high-energy waves and particles (B. Fraboni et al., Adv. Mater. 2012, 24, 2289). A film wherein the first and the second organic materials are organic materials suitable for the detection of high-energy waves and particles is, for example, advantageously suitable for use in detectors for the direct detection of high-energy waves and particles, which may be based on the generation of free charge carriers after absorption or reflection of the high-energy waves and particles, the free charge carriers giving rise to a measurable electrical signal.

The directional technique may typically also be referred to as a directional solidification or a directional crystallization technique. The resulting first crystalline layer may typically be composed of one or more single-crystalline domains of the first organic material. In embodiments, the directional technique may be a directional deposition or a directional annealing technique. In embodiments, the directional deposition technique may be a solution based processing technique, such as a meniscus guided coating technique. Meniscus guided coating techniques comprise for example dip coating, zone casting, hollow pen writing, blade coating, slot die coating and solution shearing. In embodiments, the directional annealing technique may be a directional thermal annealing by sweeping through a thermal gradient. Other directional annealing techniques may be based on annealing by solvation or by electromagnetic fields. In preferred embodiments, the directional technique may be performed at 100 °C or below, preferably 50 °C or below, yet more preferably 30 °C, such as at room temperature. Not performing the directional technique at elevated temperatures advantageously reduces the formation of cracks in the film, which may be related to different thermal expansion coefficients of the substrate and the first organic material or to polymorphism upon cooling the film.

In embodiments, the vapour-based deposition technique may be a thermal evaporation technique. In embodiments, the second crystalline layer provided in step b may be formed by evaporating from 1 to 1000, preferably from 1 to 50, more preferably from 4 to 20 single-layers of the first organic material or of a second organic material on top of the layer of the first organic material. 1000 single-layers is a preferred maximum for optical applications while 50 single-layers is a preferred maximum for thin film transistor applications.

In preferred embodiments, when the first organic material is used for both step a and step b, the first organic material is preferably suitable for growth into crystalline layers using a (low temperature) solution processing technique while also being suitable for growth into crystalline layers using a vacuum deposition technique. This means that in these embodiments, the first organic material may be soluble in at least one solvent (preferably at room temperature) and may be vaporizable (i.e. having a vaporization temperature lower than its decomposition temperature).

In preferred embodiments, the first and/or second organic material may be selected from 2,7-dioctyl[1]benzothieno[3,2-b][1]benzothiophene (C$_8$-BTBT), 3,11-didecyldinaphtho[2,3-d:2',3'-d']benzo[1,2-b:4,5-b']dithiophene (C$_{10}$-DNBDT), 2,9-didecyldinaphtho[2,3-b:2',3'-f]thieno[3,2-b]thiophene (C$_{10}$-DNTT) or from V-shaped organic semiconductors, such as C$_{10}$-DNT-VV, C$_{10}$-DNT-VW or C$_6$-DNT-VW (Okamoto, T. et al. (2013), Adv. Mater., 25: 6392-6397). These materials can advantageously both be grown into crystalline layers using a (low temperature) solution processing technique and also be vacuum deposited, thus advantageously being suitable as first organic material, second organic material, or both.

The crystalline organic film may typically cover an area of the substrate of from 10 $\mu m^2$ to 10 $m^2$, such as from 1 $mm^2$ to 1 $m^2$. The film may uniformly cover the substrate over this area, i.e. the film may comprise a bottom part being continuous, homogeneous and spanning the whole area. In preferred embodiments, the bottom part may be single-crystalline. In other embodiments, the bottom part may consist of single-crystalline domains. The domains will typically have a similar orientation, but a small lateral (e.g. 1 to 25 A) or orientational (1 to 45°) mismatch between two domains may nevertheless be present, and might prevent them from merging together into a larger single-crystalline domain.

In a second aspect, the present invention relates to a structure obtainable by the method of any embodiment of the first aspect.

In embodiments, the different features of the second aspect and its embodiments may independently be as correspondingly described for the first aspect and its embodiments.

In a first mode of realization of the second aspect, the present invention relates to a structure comprising:

i. a substrate, and
ii. a crystalline organic film made of a single material, overlying the substrate, comprising a bottom part in contact with the substrate, said bottom part being continuous, homogeneous, single-crystalline and spanning the whole area of the crystalline organic film, said crystalline organic film being at least 5 $\mu m$ wide and at least 5 $\mu m$ long.

In preferred embodiments, the bottom part may be defect-free.

In preferred embodiments, the crystalline organic film may be at least 300 $\mu m$ wide, preferably at least 1 mm wide, most preferably at least 3 mm wide.

In preferred embodiments, the crystalline organic film may be at least 300 $\mu m$ long, preferably at least 1 mm long, most preferably at least 3 mm long.

In most preferred embodiments, the crystalline organic film may be at least 300 $\mu m$ wide and at least 300 $\mu m$ long, preferably at least 1 mm wide and 1 mm long, more preferably at least 3 mm wide and 3 mm long.

The method of the present invention enables the formation of very large crystalline organic films, without actual limitation on the length or width that can be achieved.

For example, to fabricate a transistor array, one can first coat a film, according to an embodiment of the present invention, that has the dimensions of the substrate (e.g. 220 x 250 cm). Then the film can be substractively patterned into individual TFTs. 3x3mm can generally be considered an upper size limit for a single TFTs.

In optical applications such as X-ray detection, solar cell, or optical modulator no or few patterning steps are required and the active film may have the same dimensions as the substrate.

In embodiments, the crystalline organic film may have a top part, in contact with the bottom part, said top part presenting morphological defects. The morphological defects may be openings exposing the first part. These openings may for instance be voids or cracks. This embodiment is the structure typically obtained when only a first organic material is used for both step a and step b. Indeed, step b will correct the defects eventually present in the layer deposited in step a, thereby forming the bottom part of the present embodiment, but step b will also add material on the non-defective zones of the layer deposited in step a, hence forming a top part in which the defects, present after step a, have been transferred. In thin film transistor applications, the presence of the top part is not of high relevance. What matters is the quality of the bottom part as it is that part which is critical for the electronic properties of the transistor.

A particular example of crystalline organic film according to an embodiment of the first mode of realization of the second aspect may be a structure comprising:

-    a substrate,
-    a crystalline organic film made of a single material, overlying the substrate, comprising a bottom part in contact with the substrate, said bottom part being continuous, homogeneous, single-crystalline and spanning the whole area of the crystalline organic film, said area being at least 10 $\mu m^2$, and a top part, in contact with the bottom part, said top part presenting voids between ribbon-shaped single-crystalline domains.

The ribbon-shaped single-crystalline domains may for instance have a length of from 0.5 $\mu m$ to 10 m and a width of from 0.5 to 20 $\mu m$, preferably from 1 to 10$\mu m$.

The voids between the ribbon-shaped single-crystalline domains may for instance have a length of from 0.5 $\mu m$ to 10 m and a width of from 0.1 to 10 $\mu m$, preferably from 0.5 to 5 $\mu m$.

In embodiments, the different features of this first mode of realization and its embodiments may independently be as correspondingly described for the first aspect and its embodiments.

In a second mode of realization of the second aspect, the present invention relates to a structure comprising:

i. a substrate,
ii. a crystalline organic film overlying the substrate, comprising:

ii.a. a first crystalline layer of a first organic material on top of the substrate, the first crystalline layer comprising a morphological defect,

ii.b. a second crystalline layer of a second organic material, on top of the first crystalline layer and at least partially filling the morphological defect.

A particular example of embodiment of the second mode of realization of the second aspect is a structure comprising:

i. a substrate,

ii. a crystalline organic film overlying the substrate, comprising:

ii.a. a first crystalline layer of a first organic material on top of the substrate, the first crystalline layer comprising voids between ribbon-shaped single-crystalline domains,

ii.b. a second crystalline layer of a second organic material, on top of the first crystalline layer and at least partially filling the voids.

The ribbon-shaped single-crystalline domains may for instance have a length of 0.5 $\mu$m or more such as from 0.5 $\mu$m to 10 m, and a width of from 0.5 $\mu$m to 20 $\mu$m, preferably from 1 to 10 $\mu$m.

The voids between the ribbon-shaped single-crystalline domains may for instance have a length of 0.5 $\mu$m or more, such as from 0.5 $\mu$m to 10 m, and a width of from 0.1 $\mu$m to 10 $\mu$m, preferably from 0.5 to 5$\mu$m.

In a third aspect, the present invention relates to a use of a vapour deposition apparatus to repair defects in a crystalline organic film deposited by a directional technique.

In embodiments, the different features of the third aspect and its embodiments may independently be as correspondingly described for the first aspect and its embodiments.

In a further aspect, the present invention relates to the manufacture of a thin film transistor comprising the steps of providing a substrate and forming an assembly thereon, the assembly comprising a gate layer, a dielectric layer, a semiconductor crystalline organic film, a source and a drain contact, wherein:

a. the dielectric layer separates the gate layer from the semiconductor crystalline organic film,

b. the source and the drain contact are in physical and electrical contact with the semiconductor crystalline organic film, wherein the semiconductor crystalline organic film is formed by:

o providing, by a directional technique, a first crystalline layer of a first semiconductor organic material, and
o providing, by a vapour-based deposition technique, a second crystalline layer of the first semiconductor organic material or of a second semiconductor organic material on top of the first crystalline layer of the first organic material.

In embodiments, the gate layer may be on the substrate and the semiconductor crystalline organic film may be provided on the dielectric layer. This is the case for so called bottom gate (BG) TFTs such as bottom gate top contact (BGTC) TFTs and bottom gate bottom contact (BGBC) TFTs. In these embodiments, if the contacts are on top of the semiconductor crystalline organic film, the device is called a BGTC TFT while if the contacts are on top of the dielectric layer, the device is called a BGBC TFT.

In other embodiments, it is the semiconductor crystalline organic film which may be provided on the substrate and the gate is then on the dielectric layer. This is the case for so called top gate (TG) TFTs such as bottom contact top gate (BCTG) TFTs and top contact top gate (TCTG) TFTS. In these embodiments, if the contacts are on top of the semiconductor crystalline organic film, the device is called a TCTG TFT while if the contacts are on top of the substrate, the device is called a BCTG TFT.

In embodiments, the gate layer may comprise a metal or a doped semiconductor material. In embodiments, the gate layer and/or the dielectric layer may each be patterned.

In embodiments, the different features of this further aspect and its embodiments may independently be as correspondingly described for the first aspect and its embodiments.

The invention will now be described by a detailed description of several embodiments of the invention. It is clear that other embodiments of the invention can be configured according to the knowledge of the person skilled in the art without departing from the true technical teaching of the invention, the invention being limited only by the terms of the appended claims.

Example 1a: Fabrication of films and thin film transistors using the same first and second material

Crystalline organic films were made wherein the same organic material was evaporated to fill the morphological defects in a crystalline layer of a first organic material.

*Materials:* $C_8$-BTBT was purified before usage in a tri-zone purification oven from Creaphys. Solutions were prepared in anhydrous heptane (99 %, Sigma Aldrich) with a concentration of 0.25 wt%. Highly doped silicon substrates with a 125 nm thick thermally grown $SiO_2$ layer served as the substrates, providing a common gate and dielectric for the OTFT fabrication. The samples were cleaned in subsequent ultra-sonic baths of detergent, de-ionized water, acetone and iso-propanol. After a 15 min UV treatment, the samples were put in a silane oven for 1 hour to deposit trichloro(phenethyl)silane (PETS). STXM measurements were performed on silicon nitride membranes from Silson Ltd with 100nm membrane thickness.

*Film preparation and characterization:* Zone casting experiments were done on a homebuilt slot-die coater as described in Janneck, R., et al. (2016) Predictive Model for the Meniscus-Guided Coating of High- Quality Organic Single-Crystalline Thin Films. Adv. Mater. (doi:10.1002/adma.201602377. All the experiments were carried out at room temperature. An initial drop of 60 $\mu$l solution was injected into the slot-die blade by an automatic syringe pump in order to fill the dead space inside the blade and form the initial drop in contact with the substrate. Afterwards the substrate was translated by a stepper motor at a speed of 24.7 $\mu$m/s. To keep the meniscus shape constant during the coating process, solution was added by the syringe pump at a resupply rate of 15-20 $\mu$l/min. Afterwards films of $C_8$-BTBT were vacuum deposited at a deposition rate of 0.15 A/s while the substrate remained at room temperature.

*Transistor fabrication:* 60 nm thick gold source and drain contacts were deposited by vacuum evaporation through a shadow mask at a deposition rate of 1 A/s and a substrate temperature of -5 °C. The channel length and width was 190 $\mu$m and 2035 $\mu$m, respectively. To ensure good electrical characteristics, the samples were annealed in a $N_2$-filled glove box at a temperature of 50 °C for 40 hours.

Example 2: Characteristics of the films prepared in example 1

The characteristics of the films prepared in example 1 were examined. AFM studies were performed using a Bruker dimension edge scanning probe in tapping mode.

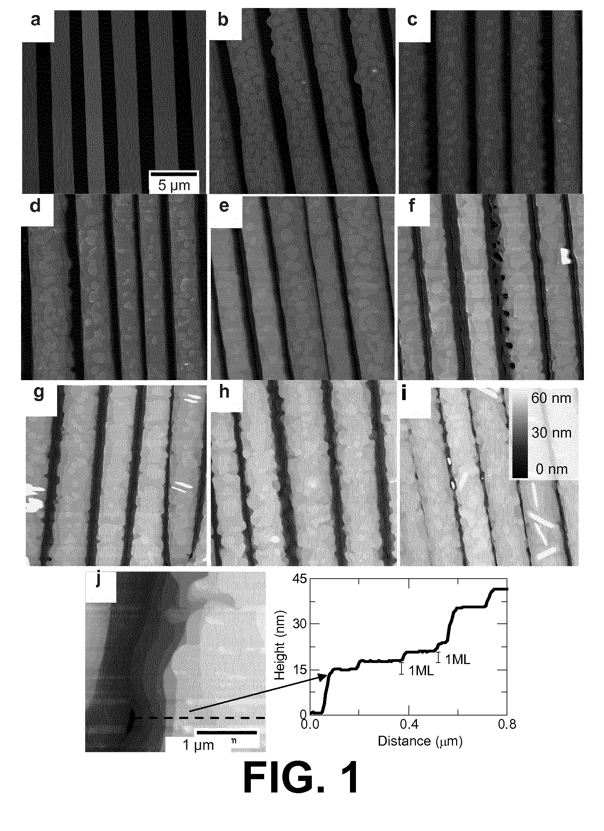

We now refer to Fig 1, showing the growth of an increasing amount of evaporated monolayers on the zone casted crystalline layer. Fig. 1a shows a regular zone casted sample. Figs. 1b-i show zone casted samples with different amount of epitaxially grown monolayers: b ½ monolayer, c 1 monolayer, d 2 monolayer, e 3 monolayer, f 5 monolayer, g 7 monolayer, h 10 monolayer, i 20 monolayer. The scale bar depicted in Fig.1a also applies to Fig. 1b-i. Fig. 1j shows an AFM image of the gap area in between two ribbons after evaporating 7 monolayers, accompanied by a depth profile corresponding to the indicated line. The grey scale is the same for all images.

Even though the films obtained after zone casting (step a) are highly crystalline layers, with a long range orientation aligned over areas of several millimeters (not shown), these films nevertheless show a pronounced ribbon-like growth (Fig. 1 a). The uniform size of these ribbons is due to fingering instabilities and dendritic growth, which result in aligned ribbons parallel to the pulling direction, with voids between the ribbons in the range of a few micrometers.

Initially, the evaporated film starts to form islands on top of the ribbons when evaporating half a monolayer of $C_8$-BTBT on top of the $C_8$-BTBT crystalline ribbons (Fig. 1 b). After around one evaporated monolayer these island wet the whole surface of the ribbons and form a flat, continuous monolayer on top of the initial crystalline layer (Fig. 1c). Afterwards new islands start to grow on top of the evaporated, flat layer. The growth continues like this in the vertical direction afterwards. Meanwhile there is no nucleation happening inside the gap between the ribbons. Instead the ribbons start to widen and narrow the gap (Fig. 1 d+e).

This growth suggests that the molecules that land in the gap diffuse towards the edge of the ribbon and attach to its side. This diffusion behavior is validated when analyzing the height profile within two ribbons just before the gap is about to be closed (Fig. 1j). A line scan of the profile height shows clear steps with step heights around 2.9 nm, corresponding to the d-spacing of $C_8$-BTBT. These molecular steps indeed suggest that the molecules are diffusing towards the ribbon boundaries and attach on the side wall of the ribbon.

Once the gap becomes narrow enough, newly arriving molecules start to connect two neighboring ribbons after around five evaporated monolayers (Fig. 1f). Afterwards further evaporation leads to further closing of the gaps until finally after ten monolayers (29 nm) the film seems to be completely closed at the interface to the substrate. Further evaporation leads to further widening of the initial ribbons until finally also layers on the top side of the initial ribbons start to meet each other (Fig. 1j). While the ribbons widen, there is no boundary to the initial ribbon width visible anymore. Hence, the newly arriving molecules form a continuous layer with the initial ribbons. Moreover, the films start to show the typical terrace like growth of $C_8$-BTBT on top of the (widened) ribbons.

As newly arriving molecules diffuse towards the edge of the initial ribbon and attach to its side, it is likely that they have the same crystalline orientation as the initial single crystalline ribbon. Therefore, it can be assumed that the growth behavior is homoepitaxial at least for the important first few monolayers on top of the substrate, in the valley between two ribbons. Indeed, X-ray diffraction (XRD) analyses (not shown) have indicated that the d-spacing in z-direction is conserved during the evaporation of additional monolayers.

Example 3: Fabrication of films using the same first and second material on a silicon nitride substrate for in depth morphological analysis.

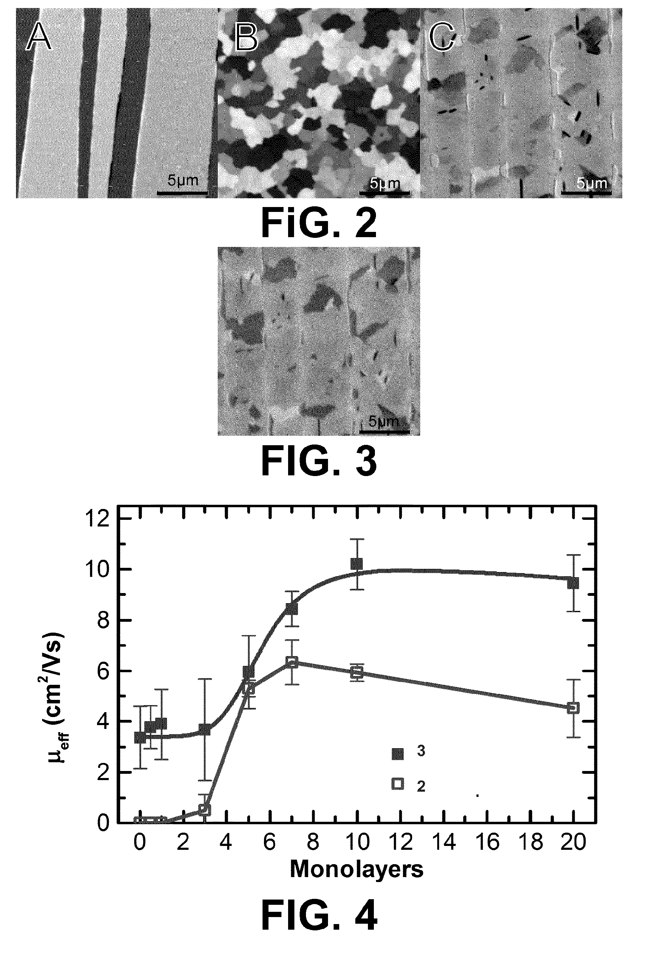

In order to gain further insight on the morphology of the prepared films, example 1 was repeated except that the substrate was this time silicon nitride membranes from Silson Ltd with membrane sizes of 1.0 mm x 1.0 mm, membrane thicknesses of 100 nm and a frame thickness of 200 $\mu$m. STXM measurements were performed at the NanoXAS beamline at the Swiss Light Source, Paul Scherrer Institut, Villigen, Switzerland. Transmission measurements (Fig. 2) were detected by a silicon avalanche photo diode. Surface sensitive electron detection were performed simultaneously with x-ray transmission measurements and were detected by a channeltron (Fig. 3).

In these images, a same shade of grey corresponds to a same crystalline orientation. As expected, each crystallite in the zone-casted films (A, step a alone) has a perfect single crystalline character, as indicated by the full ribbon having the same grey shade. Also the three parallel ribbons in Fig. 2A have the same shade of grey, indicating that all three have the same crystalline orientation. This is a common observation in unidirectional crystallization techniques: Although parallel ribbons are spatially separated by wide gaps, they have the same crystalline orientation. Indeed, all ribbons stem from the same nucleation event at the origin that subsequently split into many parallel ribbons during unidirectional motion for reasons related to the complex kinetics of growth. The sample fabricated by thermal evaporation only (B, step b alone) formed polycrystalline layers with grain sizes in the range of few micrometres, as indicated by different regions with different shade of grey. The samples prepared according to an embodiment of the present invention (C, step a + step b) showed an almost perfectly uniform shade across the whole scanned area. Only few randomly located darker and brighter spots are visible, indicative of few regions with different crystalline orientations across the scanned area. As they are also visible in the surface sensitive measurements (Fig.3), it suggests that only the top layer has a different crystalline orientation in these areas. This suggests that the first few interfacial layers are single-crystalline in nature. As the majority of current transport happens in these layers close to the interface with the gate dielectric, we can assume that the current transport happens across a single crystalline layer. Remarkably, we notice that the initial ribbon region is not distinguishable anymore from the initial gap regions. Hence newly arriving molecules during the thermal evaporation process are attaching to the sides of the ribbons and widen them without changing the crystalline orientation and without leaving behind a grain boundary at the initial edge of the ribbons. This happens until the ribbons have perfectly bonded to each other. From this we gather that the growth is homo-epitaxial in nature, as the crystalline orientation of the underlying layer is conserved and the same molecule is used.

Example 4: Characteristics of the thin film transistors prepared in example 1

The characteristics of the TFTs prepared in example 1 were examined. Electrical characterizations were done using an Agilent Agt1500 in dry air. Field-effect mobilities were evaluated in the saturation regime by conventional transconductance analysis given by $\mu_{FET} = (2L/W)(1/C_i)\left(\partial\sqrt{I_D}/\partial V_G\right)^2$.

We now refer to Fig. 4, showing the electrical performance of a film made by regular evaporation directly on the substrate as a function of the thickness of the evaporated film (step b alone, curve 2, white squares). Above 4 monolayer thickness, a sudden increase in effective mobility was observed, which is attributed to the coalescence of individual islands in the polycrystalline film. Performance peaked at 7 monolayer thickness and then slowly decreased; this is attributed to the detrimental effect of contact resistance increasing with film thickness. Fig. 4 also shows the electrical performance of films prepared according to an embodiment of the present invention (step a + step b, curve 3, black squares). The behaviour with evaporated thickness was similar to the previous case: a sudden rise above 4 monolayer thickness, a peak at about 10 monolayer thickness followed by a small decrease at higher thicknesses. The sudden rise here is attributed to the coalescence of neighbouring ribbons during their lateral growth.

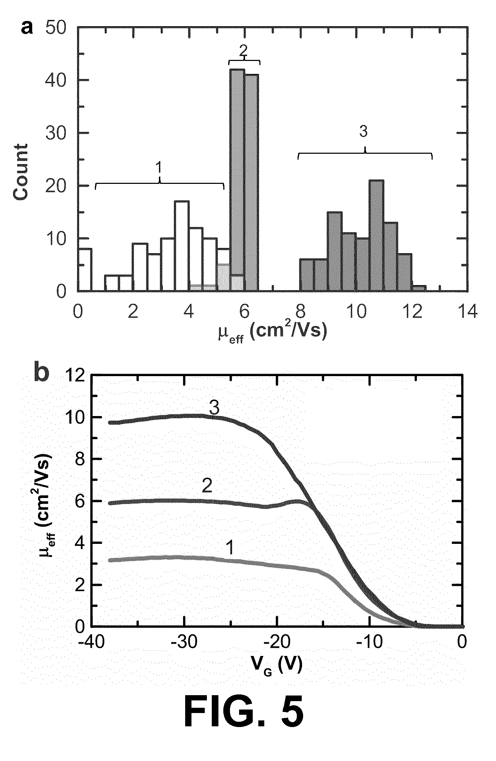

We now refer to Fig. 5. TFTs fabricated according to the method of the present invention (see example 1, step a + b, group 3 in Fig. 5) were compared with results of individual reference samples of only zone casting (step a, group n°1 in Fig. 5) and only evaporation (step b, group n°2 in Fig. 5)). This shows that the mobility of the film obtainable by the present invention is about twice as large as the mobility obtained by a regular evaporation and about three times larger than the mobility obtained by regular directional deposition. In consequence, films prepared according to an embodiment of the present invention (step a + step b) see a significant improvement in mobility as compared to films prepared using methods according to the prior art (either step a or step b alone). Besides, the histograms in Fig.5a reveal the spread in electrical characteristics of the three different films. Films prepared according to an embodiment of the present invention (step a + step b) have a lowering by a factor 3 of the variability of their electrical characteristics, as compared to the films prepared by regular directional deposition (step a alone).

It has been shown that device characteristics that deviate too far from the idealized current-voltage characteristics can lead to an overestimation of the mobility by more than an order of magnitude. Hence direct comparison of the hole mobility to values reported in literature is difficult. However, when dismissing the overestimation at low gate bias, we can compare respective aggregate mobilities, which better represent the true mobility used in actual circuitry. Once neglecting values extracted from non-ideal IV-characteristics or estimating their correct value, we notice that our measured aggregate mobilities exceed previously obtained hole mobilities for $C_8$-BTBT with the first time average aggregate values reaching beyond 10 $cm^2/Vs$ (see table 1).

Table 1:

| Author | Molecule | Technique | $\mu_{eff, max}$ [$cm^2/Vs$] | $\mu_{eff, avg}$ [$cm^2/Vs$] | Average spread | Max to average deviatio n |
|---|---|---|---|---|---|---|
| Endo | $C_8$-BTBT | Spin coating | 3 | 1.59+-0.40 | 25.2% | 88.7% |
| Liu | $C_8$-BTBT | Solution annealing | 9.1 | 3.0+-2.0 | 67% | 203% |
| Uemura | $C_8$-BTBT | Edge casting | 10 | N/A | N/A | N/A |
| Janneck | $C_8$-BTBT | Zone casting | 7 | 4.3+-1.4 | 32.6% | 62.8% |
| Example 1 | $C_8$-BTBT | Epitaxial regrowth | 13 | 10.0+-1.1 | 11% | 30% |

Endo refers to Endo, T., Nagase, T., Kobayashi, K., Takimiya, M., Ikeda, M. & Naito, H. Solution-processed dioctylbenzothienobenzothiophene-based top-gate organic transistors with high mobility, low threshold voltage, and high electrical stability. Appl. Phys. Express 3, 8-10 (2010).

Liu refers to Liu, C., Minari, T., Lu, X., Kumatani, A., Takimiya, K. and Tsukagoshi, K. Solution-processable organic single crystals with bandlike transport in field-effect transistors. Adv. Mater. 23, 523-526 (2011).

Uemura refers to Uemura, T., Nakayama, K., Hirose, Y., Soeda, J., Uno, M., Li, W., Yamagishi, M., Okada, Y. & Takeya, J. Band-like transport in solution-crystallized organic transistors. Curr. Appl. Phys. 12, 87-91 (2012).

Janneck refers to Janneck, R., Vercesi, F., Heremans, P., Genoe, J. & Rolin, C. Predictive Model for the Meniscus-Guided Coating of High- Quality Organic Single-Crystalline Thin Films. Adv. Mater. 36, 8007-8013 (2016).

This value above 10 $cm^2/Vs$ is only surpassed by some recently invented small molecules such as $C_{10}$-DNBDT (C. Mitsui et al., Adv. Mater. 2014, 26, 4546., Ph-BTBT-10 or DBTTT (Jeong-Il Park et al., J. Am. Chem. Soc., 2015, 137 (38), pp 12175-12178) which are not commercially available. Employing the dual step technique of the present invention (step a + step b) to form films of these new semiconductor materials can be expected to push their performance even higher. Moreover, when comparing the deviation in electrical characteristics of our samples (uniformity within one sample and from sample-to-sample) to values reported in literature for single crystalline devices, we notice a clear advantage of our technique. To evaluate the deviation of our samples, 6 samples were prepared individually on different dates. FET mobilities were averaged over 90 devices formed on each sample. The results are shown in Table 2 below and the average spread for the TFTs prepared in example 1 is compared to values of the literature in Table 1. The 'average spread' in table 2 is the spread of the standard deviation with respect to the average mobility, while the 'max to average deviation' is the difference between the maximum mobility and the average mobility, divided by the average mobility.

Table 2:

| Sample | $\mu_{eff, avg}$ [$cm^2/Vs$] | $\mu_{eff, max}$ [$cm^2/Vs$] | Average spread | Max to average deviation |
|---|---|---|---|---|
| 1 | 10.3+-1.4 | 13.0 | 13.6% | 26.2% |
| 2 | 9.5+-0.8 | 11.1 | 8.4% | 16.8% |
| 3 | 9.9+-1.0 | 11.3 | 10.1% | 14.1% |
| 4 | 10.1+-1.3 | 12.8 | 12.9% | 26.7% |
| 5 | 10.2+-1.0 | 12.3 | 9.8% | 20.6% |
| Average all | 10.0+-1.1 | 13.0 | 11.0% | 30% |

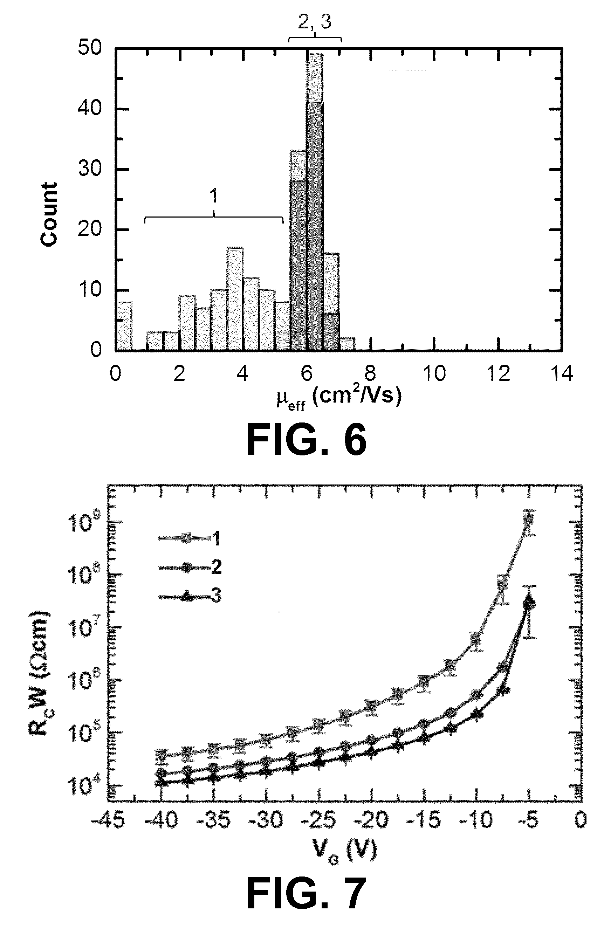

Fig. 7 shows the typical contact resistance of the different fabrication techniques: zone casting (step a alone, 1, prior art), evaporation (step b alone, 2, prior art) and zone casting followed by evaporation (step a + step b, 3, embodiment). Contact resistances were extracted by the conventional transmission line method. Transistor channel lengths varied from 195 $\mu$m to 30 $\mu$m with a total of eight different channel lengths. For each channel length 30 transistors were measured and averaged to extract accurate values. Fig. 7 demonstrates that the sample prepared according to an embodiment shows lower contact resistance $R_cW$ than the samples prepared using methods according to the prior art (either step a or step b alone).

Example 5: Fabrication and characteristics of films and thin film transistors using different first and second materials

Crystalline organic films were made wherein a second organic material ($C_{10}$-DNTT) was evaporated to fill the morphological defects in a crystalline layer of a first organic material ($C_8$-BTBT).

Zone casting experiments were performed as described in example 1: 0.25 wt% $C_8$-BTBT was dissolved in heptane and then zone-casted at room temperature with a coating speed of 24.7 $\mu$m/s. The evaporation of $C_{10}$-DNTT was done in the same way as for $C_8$-BTBT: 0.15 A/s evaporation speed while the substrate remained at room temperature.

We now refer to Fig. 6. It was observed that films of evaporated $C_{10}$-DNTT (i.e. step b only; 2) behave similarly to films of evaporated $C_8$-BTBT (2; Fig. 5), with mobilities reaching around 6 $cm^2$/Vs. As the molecules behave similarly it could be reasonable to assume that $C_{10}$-DNTT will also close the gaps in $C_8$-BTBT and could lead to similar electrical improvement of the first crystalline $C_8$-BTBT layer. Indeed, an improvement of a factor 2 between the zone casted film (step a alone) and the film according to an embodiment of the present invention (step a +b) was observed (not shown), compared to the factor of 3 (Fig. 5a; 1 vs 3) for the case of both materials being $C_8$-BTBT. Hence, it is possible to bridge the openings and cracks by evaporating a different material on top of a first crystalline layer, thereby obtaining a stark improvement in the quality (hole mobilities) of the film. However, this does not result in the highest possible performance improvement, which can be attributed to the absence of homoepitaxial growth and therefore to a lower crystallinity.

It is to be understood that although preferred embodiments, specific constructions and configurations, as well as materials, have been discussed herein for devices according to the present invention, various changes or modifications in form and detail may be made without departing from the scope and technical teachings of this invention. For example, any formulas given above are merely representative of procedures that may be used. Functionality may be added or deleted from the block diagrams and operations may be interchanged among functional blocks. Steps may be added or deleted to methods described within the scope of the present invention.

**Claims**

1.    A method for forming a crystalline organic film, comprising the steps of:

    a. providing, by a directional technique, a first crystalline layer of a first organic material on top of a substrate, and
    b. providing, by a vapour-based deposition technique, a second crystalline layer of the first organic material or of a second organic material on top of the first crystalline layer of the first organic material.

2.    The method according to claim 1, wherein the first crystalline layer provided in step a comprises at least a morphological defect.

3.    The method according to claim 2, wherein the first crystalline layer is composed of one or more single-crystalline domains of the first organic material, the at least one morphological defect being present in at least one of the one or more single-crystalline domains and/or between two or more of the single-crystalline domains.

4.    The method according to claim 2 or 3, wherein step b at least partially fills the at least one morphological defect with a crystalline layer of the first organic material or of a second organic material.

5.    The method according to claim 4, wherein the at least one morphological defect has a bottom in contact with the substrate and a top away from the substrate, and wherein step b fills completely the bottom of the at least one morphological defect.

6.    The method according to claim 4 or 5, wherein the second crystalline layer is a layer of the first organic material and wherein the filling occurring in step b operates by homoepitaxial growth within the morphological defect.

7.    The method according to any one of claims 1 to 6, wherein the vapour-based deposition technique is a thermal evaporation technique.

8. The method according to any one of claims 1 to 7, wherein the second crystalline layer provided in step b is formed by evaporating from 1 to 1000, preferably from 1 to 50, more preferably from 4 to 20 single-layers of the first organic material or of a second organic material on top of the layer of the first organic material.

9. The method according to any of the previous claims, wherein the directional technique is a directional deposition technique or a directional annealing technique.

10. The method according to claim 9, wherein the directional deposition technique is a meniscus guided coating technique.

11. The method according to claims 1 to 10, wherein the crystalline organic film has a minimal thickness of from 10 nm to 5 $\mu$m, preferably from 10 nm to 60 nm.

12. The method according to any one of the preceding claims, wherein the first and second organic materials are semiconductor materials.

13. The method according to any one of claims 1 to 12, wherein the first and/or second organic materials are organic materials with non-linear optical properties.

14. A crystalline organic film obtainable by the method of any one of claims 1 to 13.

15. Use of a vapour deposition apparatus to repair defects in a crystalline organic film deposited by a directional technique.

FIG. 1

FiG. 2

FIG. 3

FIG. 4

FIG. 5

**FIG. 6**

**FIG. 7**

a — Directional deposition of 1st layer

b — Vapor-based deposition of 2nd layer

Crystalline organic film

# FIG. 8

Europäisches
Patentamt

European
Patent Office

Office européen
des brevets

# EUROPEAN SEARCH REPORT

Application Number

EP 16 19 1209

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | CHIKAHIKO MITSUI ET AL: "High-Performance Solution-Processable N-Shaped Organic Semiconducting Materials with Stabilized Crystal Phase", ADVANCED MATERIALS, vol. 26, no. 26, 8 July 2014 (2014-07-08), pages 4546-4551, XP055355765, DE ISSN: 0935-9648, DOI: 10.1002/adma.201400289 | 1,2,4, 7-14 | INV. C30B7/06 C23C14/00 C30B23/02 C30B25/18 C30B29/54 |
| A | * "Experimental Section" * * page 4549, left-hand column, lines 1-2 * ----- | 6 | |
| X,D | TOSHIHIRO OKAMOTO ET AL: "V-Shaped Organic Semiconductors With Solution Processability, High Mobility, and High Thermal Durability", ADVANCED MATERIALS, vol. 25, no. 44, 23 November 2013 (2013-11-23), pages 6392-6397, XP055355791, DE ISSN: 0935-9648, DOI: 10.1002/adma.201302086 | 1,2,4, 7-14 | |
| A | * "Experimental Section" * * page 6395, left-hand column, lines 55-59 * ----- -/-- | 6 | TECHNICAL FIELDS SEARCHED (IPC) C30B C23C |

The present search report has been drawn up for all claims

| Place of search | Date of completion of the search | Examiner |
|---|---|---|
| The Hague | 21 March 2017 | Schmitt, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 16 19 1209

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MASSIMILIANO CAVALLINI ET AL: "Ambipolar Multi-Stripe Organic Field-Effect Transistors", ADVANCED MATERIALS, vol. 23, no. 43, 16 November 2011 (2011-11-16), pages 5091-5097, XP055356678, DE ISSN: 0935-9648, DOI: 10.1002/adma.201103439 | 1-5, 7-10, 12-15 | |
| A | * figure 1 * * page 5091, right-hand column, line 28 - page 5092, right-hand column, line 18 * ----- | 6 | |
| | | | TECHNICAL FIELDS SEARCHED (IPC) |

The present search report has been drawn up for all claims

| Place of search | Date of completion of the search | Examiner |
|---|---|---|
| The Hague | 21 March 2017 | Schmitt, Christian |

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **U. THIELE et al.** *Adv. Colloid Interface Sci.,* 2014, vol. 206, 399
- **Y. LI et al.** *Sci. Rep.,* 2016, vol. 6, 32620
- **B. FRABONI et al.** *Adv. Mater.,* 2012, vol. 24, 2289
- **OKAMOTO, T. et al.** *Adv. Mater.,* 2013, vol. 25, 6392-6397
- **JANNECK, R. et al.** Predictive Model for the Meniscus-Guided Coating of High- Quality Organic Single-Crystalline Thin Films. *Adv. Mater.,* 2016
- **ENDO REFERS TO ENDO, T. ; NAGASE, T. ; KOBAYASHI, K. ; TAKIMIYA, M. ; IKEDA, M. ; NAITO, H.** Solution-processed dioctylbenzothienobenzothiophene-based top-gate organic transistors with high mobility, low threshold voltage, and high electrical stability. *Appl. Phys. Express,* 2010, vol. 3, 8-10
- **LIU, C. ; MINARI, T. ; LU, X. ; KUMATANI, A. ; TAKIMIYA, K. ; TSUKAGOSHI, K.** Solution-processable organic single crystals with bandlike transport in field-effect transistors. *Adv. Mater.,* 2011, vol. 23, 523-526
- **UEMURA REFERS TO UEMURA, T. ; NAKAYAMA, K. ; HIROSE, Y. ; SOEDA, J. ; UNO, M. ; LI, W. ; YAMAGISHI, M. ; OKADA, Y. ; TAKEYA, J.** Band-like transport in solution-crystallized organic transistors. *Curr. Appl. Phys.,* 2012, vol. 12, 87-91
- **JANNECK, R. ; VERCESI, F. ; HEREMANS, P. ; GENOE, J. ; ROLIN, C.** Predictive Model for the Meniscus-Guided Coating of High- Quality Organic Single-Crystalline Thin Films. *Adv. Mater.,* 2016, vol. 36, 8007-8013
- **C. MITSUI et al.** *Adv. Mater.,* 2014, vol. 26, 4546
- **JEONG-II PARK et al.** *J. Am. Chem. Soc.,* 2015, vol. 137 (38), 12175-12178